# EUROPEAN PATENT SPECIFICATION

(11) **EP 0 770 878 B1**
(45) Date of publication and mention of the grant of the patent: **16.07.2003**
(21) Application number: 96115906.8
(22) Date of filing: 04.10.1996
(51) Int. Cl.: G01R 11/04, G01R 1/04

(54) **Improvements in or relating to meters**
Verbesserungen von Zählern
Améliorations concernant des compteurs

(30) Priority: 26.10.1995 GB 9521914
(43) Date of publication of application: 02.05.1997
(73) Proprietor: Landis & Gyr Limited, Telford, Shropshire TF1 7YG (GB)
(72) Inventor: Warwick, Ronald, Liverpool, L18 2ON (GB); Rothwell, Neil, Sale, Cheshire, M33 4NE (GB)
(74) Representative: Humphrey-Evans, Edward John

(56) References cited:
- EP-A- 0 649 025
- CH-A- 595 638
- DE-A- 3 828 650
- DE-U- 9 114 854

## Description

This invention relates to meters and more especially although not exclusively it relates to electricity meters.

It is common practice to provide an electricity meter with a label which identifies its operational characteristics and/or serial number, and/or the name of a utility responsible for the metered supply; (see e.g.CH 595 638 A). It is desirable that this label should be difficult to remove so that meter characteristics can always be checked when required by authorised personnel, and yet it is sometimes desirable to change a label perhaps after a meter has been modified in use, or in store.

It is an object of the present invention to provide an electricity meter having a simple and effective labelling arrangement.

According to the present invention, a meter comprises a housing within which a meter body is contained and in which housing a meter label recess is formed, a translucent cover for the recess beneath which a label is positionable, the cover including a hole for a fixing screw which serves to hold it in position and which serves to secure the said body to said housing, and screw cover means which is positioned so as to cover the screw, which screw cover means is adapted to be sealed in position.

The label of a meter according to the present invention may thus be changed as necessary without difficulty and yet access to the label is restricted to authorised personnel. Moreover, since the label cover fixing screw serves not only to secure the label cover but also to secure the meter body to the housing, construction/assembly is simplified.

The meter may be an electricity meter.

The translucent cover may comprise a generally 'U' shaped portion which is adapted slidingly to fit over an edge of the housing so that one leg of the 'U' shaped portion defines a transparent window which fits into the recess when the cover is slid into position, thereby to cover a label when placed therein, the other leg of the 'U' shaped portion being bent to define an integral fixing plate which projects orthogonally of the legs and in which the fixing hole is formed.

One edge of the window may be shaped to fit into a complimentary shaped part of the recess when the cover is slid fully into position.

The housing may be provided with a further recess into which the fixing plate is received in contiguity with the housing when the cover is slid fully into position.

The screw cover means may comprise an 'L' shaped fixed sealing tag, one leg of which is arranged to fit over the fixing plate within the further recess so that a hole formed therein aligns with the hole in the fixing plate, whereby the fixing screw can be tightened so as to clamp the sealing tag to the fixing plate and the other leg of which includes a slot in which a tongue end of one leg of a loose 'L' shaped sealing tag is fitted so that this leg covers this screw, the loose 'L' shaped sealing tag being bent orthogonally to define the other leg in which a slot is formed which is arranged to receive a complimentary tongue of the fixed sealing tag, the tongue being adapted to receive a seal which serves to prevent its removal.

The adaptation as aforesaid of the tongue may simply comprise a hole in which a seal is secured.

The seal may comprise a sealed wire.

One embodiment of the invention will now be described by way of example only with reference to the accompanying drawings, wherein:

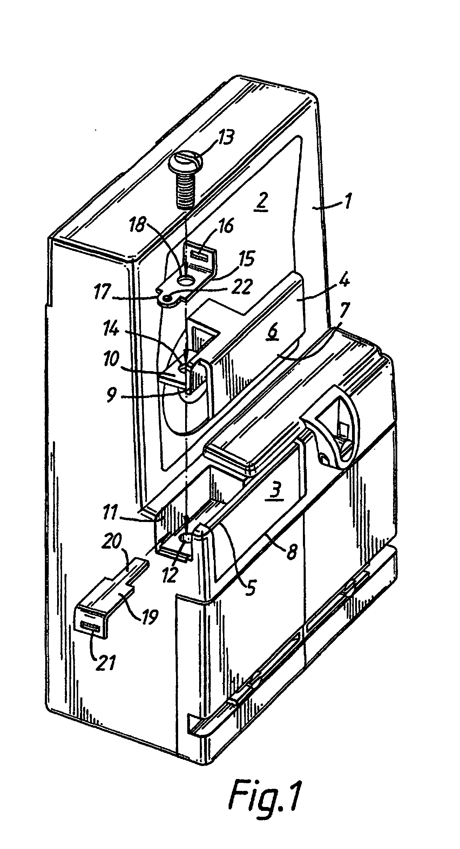

FIGURE 1 is a generally schematic part exploded perspective view of an electricity meter;

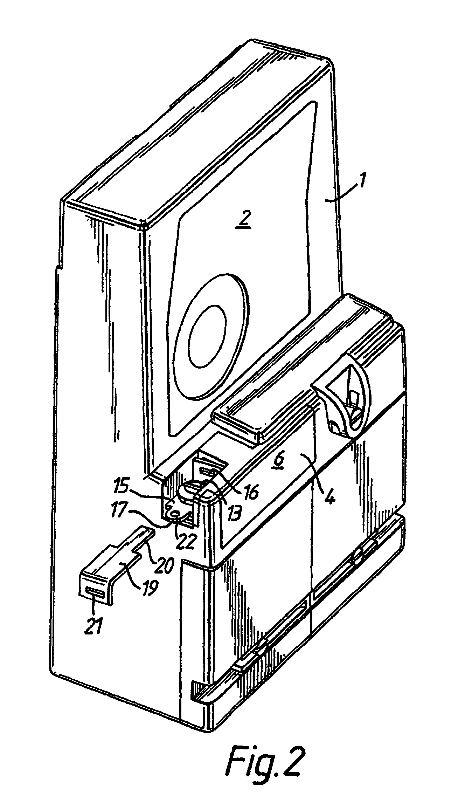

FIGURE 2 is a generally schematic part exploded perspective view corresponding substantially to Figure 1, but wherein some exploded parts are assembled; and,

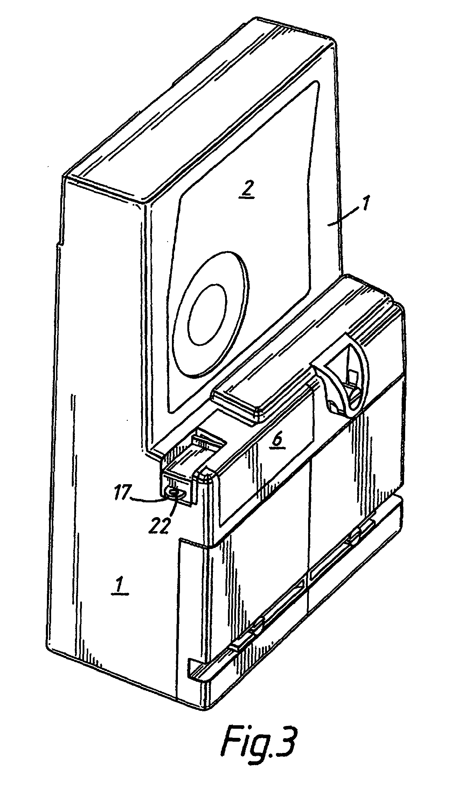

FIGURE 3 is a generally schematic perspective view corresponding to Figures 1 and 2, wherein all exploded parts are assembled.

Referring now to the drawings, wherein corresponding parts of the various Figures bear the same numerical designations, an electricity meter comprises a housing 1, including a meter display panel 2. The housing 1 is formed to include a rectangular recess 3 for an identification label which carries details of the meter including its serial number and utility data etc. A generally 'U' shaped sealing cover 4 is arranged slidably to fit over an edge 5 of the housing 1. The 'U' shaped cover 4 comprises a first leg which serves as a transparent window 6 which sits in the recess 3 so as to cover a label when placed therein. One edge portion 7 of the window 6 is chamfered so as lockingly to engage a complimentary 'V' shaped groove 8 in the recess 3 when the window 6 is slid fully into position within the recess 3. The other leg 9 of the 'U' shaped cover 4 is bent orthogonally to define a fixing plate 10, which when the cover 4 is slid into position is arranged to fix into a further recess 11 in the housing 1. In the bottom of the further recess 11, a fixing hole 12 is provided for a fixing screw 13 which is arranged to pass through a hole 14 in the fixing plate 10, whereby the sealing cover 4 can be clamped by means of the screw 13 within the recess 11 by the screw 13.

Although not shown in the drawing, the screw 13 is arranged to engage a complimentary screw threaded hole in a meter body (not shown) contained within the housing 1 so that the meter body is fixed by means of the screw 13 to the housing. In order to secure the screw 13 against unauthorised removal, a fixed 'L' shaped sealing tag 15 is provided, one leg of which includes a slot 16 and the other leg of which includes a tongue 17. A hole 18 for the screw 13 is provided in the fixed sealing tag 15 so that the tag 15 may be clamped into position on top of the sealing cover 4 by means of the screw 13. In order to conceal the screw 13 and to prevent its unauthorised removal, a loose sealing tag 19 is provided having a tongue 20 which is arranged to engage the slot 16 so that the tongue 17 of the fixed sealing tag 15 projects through a slot 21 in the loose sealing tag 19. The loose sealing tag 19 is then secured in position by means of sealing wire which is passed through a hole 22 which is formed in the tongue 17.

In the meter described above, the sealing cover 4 is locked into position by means of the screw 13 which serves also to hold the meter body securely within the housing 1, removal of the screw 13 being prevented by the loose sealing tag 19, which is engaged with the fixed sealing tag 15 and sealed thereto

## Claims

1. A meter comprising a housing (1) within which a meter body is contained and in which housing a meter label recess (3) is formed, a translucent cover (4) for the recess beneath which a label is positionable, the cover including a hole (14) for a fixing screw (13) which serves to hold it in position and which serves to secure the said body to said housing, and screw cover means (15,19) which is positioned so as to cover the screw, which screw cover means is adapted to be sealed in position.

2. A meter as claimed in Claim 1 which serves as an electricity meter.

3. A meter as claimed in Claim 1 or Claim 2, wherein the translucent cover comprises a generally 'U' shaped portion which is adapted slidingly to fit over an edge (5) of the housing so that one leg of the 'U' shaped portion defines a transparent window (6) which fits into the recess when the cover is slid into position, thereby to cover a label when placed therein, the other leg of the 'U' shaped portion being bent to define an integral fixing plate (10) which projects orthogonally of the legs and in which the fixing hole is formed.

4. A meter as claimed in Claim 3, wherein one edge (7) of the window is shaped to fit into a complimentary party (8) of the recess when the cover is slid fully into position.

5. A meter as claimed in Claim 3 or Claim 4, wherein the housing is provided with a further recess (11) into which the fixing plate (10) is received in contiguity with the housing when the cover is slid fully into position.

6. A meter as claimed in Claim 5, wherein the screw cover means comprises an 'L' shaped fixed sealing tag (15), one leg of which is arranged to fit over the fixing plate within the further recess so that a hole (18) formed therein aligns with the hole (14) in the fixing plate, whereby the fixing screw can be tightened so as to clamp the fixed sealing tag to the fixing plate and the other leg of which includes a slot (16) in which a tongue end (20) of one leg of a loose 'L' shaped sealing tag (19) is fitted so that this leg covers this screw, the loose 'L' shaped sealing tag being bent orthogonally to define the other leg in which a slot (21) is formed which is arranged to receive a complimentary tongue (17) of the fixed sealing tag, the tongue being adapted to receive a seal which serves to prevent its removal.

7. A meter as claimed in Claim 6, wherein the adaptation as aforesaid of the tongue comprises a hole (22) in which a seal is secured.

8. A meter as claimed in Claim 7, wherein the seal comprises a sealed wire.

## Patentansprüche

1. Zähler mit einem Gehäuse (1), in dem ein Zählerkörper enthalten ist und in dem eine Zählerschildausnehmung (3) ausgebildet ist, einer durchsichtigen Abdeckung (4) für die Ausnehmung, unter der ein Schild positioniert werden kann, wobei die Abdeckung ein Loch (14) für eine Befestigungsschraube (13) umfaßt, die dazu dient, sie an Position zu halten, und die dazu dient, den Körper an dem Gehäuse zu sichern, und einer Schraubenabdeckeinrichtung (15, 19), die so positioniert ist, daß die Schraube abgedeckt ist, und die in der Position versiegelt werden kann.

2. Zähler nach Anspruch 1, der als Stromzähler dient.

3. Zähler nach Anspruch 1 oder Anspruch 2, bei welchem die durchsichtige Abdeckung einen insgesamt U-förmigen Abschnitt aufweist, der gleitend über einen Rand (5) des Gehäuses eingepaßt werden kann, so daß ein Schenkel des U-förmigen Abschnitts ein transparentes Fenster bildet (6), das in die Ausnehmung paßt, wenn die Abdeckung in Position geglitten ist, um dadurch ein Schild abzudecken, wenn es darin angeordnet ist, wobei der andere Schenkel des U-förmigen Abschnitts derart gebogen ist, daß er eine integrale Befestigungsplatte (10) bildet, die orthogonal zu den Schenkeln vorsteht, und in der das Befestigungsloch ausgebildet ist.

4. Zähler nach Anspruch 3, bei welchem ein Rand (7) des Fensters derart geformt ist, daß er in einen komplementär geformten Teil (8) der Ausnehmung paßt, wenn die Abdeckung vollständig in Position geglitten ist.

5. Zähler nach Anspruch 3 oder 4, bei welchem das Gehäuse mit einer weiteren Ausnehmung (11) versehen ist, in der die Befestigungsplatte (10) angrenzend an das Gehäuse aufgenommen ist, wenn die Abdeckung vollständig in Position geglitten ist.

6. Zähler nach Anspruch 5, bei welchem die Schraubenabdeckungseinrichtung eine L-förmige, festgelegte Plombierungsfahne (15) aufweist, von der ein Schenkel angeordnet ist, damit er über die Befestigungsplatte innerhalb der weiteren Ausnehmung paßt, so daß ein darin ausgebildetes Loch (18) mit dem Loch (14) in der Befestigungsplatte ausgerichtet ist, wodurch die Befestigungsschraube derart angezogen werden kann, daß die festgelegte Plombierungsfahne an die Befestigungsplatte geklemmt wird, und deren anderer Schenkel einen Schlitz (16) umfaßt, in den ein Zungenende (20) eines Schenkels einer losen L-förmigen Plombierungsfahne (19) eingepaßt ist, so daß dieser Schenkel diese Schraube überdeckt, wobei die lose L-förmige Plombierungsfahne orthogonal gebogen ist, um den anderen Schenkel zu bilden, in dem ein Schlitz (21) ausgebildet ist, der zur Aufnahme einer komplementären Zunge (17) der festgelegten Plombierungsfahne angeordnet ist, wobei die Zunge zur Aufnahme einer Versiegelung angepaßt ist, die dazu dient, ihr Entfernen zu verhindern.

7. Zähler nach Anspruch 6, bei welchem die oben erwähnte Anpassung der Zunge ein Loch (22) aufweist, in dem eine Versiegelung gesichert ist.

8. Zähler nach Anspruch 7, bei welchem die Versiegelung einen Plombendraht aufweist.

## Revendications

1. Compteur comportant un boîtier (1) dans lequel est contenu un corps de compteur et boîtier dans lequel est formé un évidement pour étiquette de compteur (3), un couvercle translucide (4) de l'évidement, en dessous duquel une étiquette peut être positionnée, le couvercle comportant un trou (14) destiné à une vis de fixation (13) qui sert à le maintenir en position et qui sert à fixer ledit corps sur ledit boîtier, et des moyens de recouvrement de vis (15, 19) qui sont positionnés de manière à recouvrir la vis lesquels moyens de recouvrement de vis sont adaptés pour être scellés en position.

2. Compteur selon la revendication 1, qui sert en tant que compteur d'électricité.

3. Compteur selon la revendication 1 ou 2, dans lequel le couvercle translucide comporte une partie de manière générale en forme de "U" qui est adaptée de manière coulissante pour être agencée au-dessus d'un bord (5) du boîtier de sorte qu'une des jambes de la partie en forme de "U" définit une fenêtre transparente (6) qui est agencée dans l'évidement lorsque le couvercle est coulissé en position, de manière à recouvrir une étiquette lorsqu'elle est placée dans celui-ci, l'autre jambe de la partie en forme de "U" étant pliée pour définir une plaque de fixation venue de matière (10) qui fait saillie orthogonalement par rapport aux jambes et dans laquelle est formé le trou de fixation.

4. Compteur selon la revendication 3, dans lequel un bord (7) de la fenêtre est mis en forme pour s'agencer dans une partie complémentaire (8) de l'évidement lorsque le couvercle est coulissé entièrement en position.

5. Compteur selon la revendication 3 ou 4, dans lequel le boîtier est muni d'un autre évidement (11) dans lequel la plaque de fixation (10) est reçue de manière contiguë au boîtier lorsque le couvercle est coulissé entièrement en position.

6. Compteur selon la revendication 5, dans lequel les moyens de recouvrement de vis comportent une plaque de scellage fixée en forme de "L" (15), dont une jambe est agencée pour être située au-dessus de la plaque de fixation dans l'autre évidement de sorte qu'un trou (18) formé dans celle-ci est aligné avec le trou (14) de la plaque de fixation, de sorte que la vis de fixation peut être vissée de manière à serrer la plaque de scellage fixée sur la plaque de fixation et dont l'autre jambe comporte une fente (16) dans laquelle une extrémité de languette (20) d'une jambe d'une plaque de scellage en forme de "L" lâche (19) est agencée de sorte que cette jambe recouvre cette vis, la plaque de scellage en forme de "L" lâche étant pliée orthogonalement pour définir l'autre jambe dans laquelle une fente (21) est formée qui est agencée pour recevoir une languette complémentaire (17) de la plaque de scellage fixée, la languette étant adaptée pour recevoir des scellés qui servent à empêcher son enlèvement.

7. Compteur selon la revendication 6, dans lequel l'adaptation telle que mentionnée ci-dessus de-la languette comporte un trou (22) dans lequel sont fixés des scellés.

8. Compteur selon la revendication 7, dans lequel les scellés sont constitués d'un câble scellé.
